# EUROPEAN PATENT SPECIFICATION

(11) **EP 4 261 155 B1**
(45) Date of publication and mention of the grant of the patent: **25.11.2026**
(21) Application number: 21903000.4
(22) Date of filing: 13.10.2021
(51) Int. Cl.: H10P 72/30

(54) **CONVEYANCE SYSTEM**
FÖRDERSYSTEM
SYSTÈME DE TRANSPORT

(30) Priority: 10.12.2020 JP 2020205051
(43) Date of publication of application: 18.10.2023
(73) Proprietor: Murata Machinery, Ltd., Kyoto-shi, Kyoto 601-8326 (JP)
(72) Inventor: MOTOORI Yoichi, Inuyama-shi, Aichi 484-8502 (JP)
(74) Representative: Zimmermann, Tankred Klaus
(86) International application number: PCT/JP2021/037890
(87) International publication number: WO 2022/123896

(56) References cited:
- WO-A1-2014/207977
- WO-A1-2017/029871
- WO-A1-2017/043234
- WO-A1-2017/043234
- JP-A- 2009 009 365
- US-A1- 2009 238 664
- US-A1- 2017 194 181
- US-A1- 2019 006 217

## Description

### Technical Field

The present invention relates to a conveyance system.

### Background Art

For example, a system described in Patent Literature 1 is known as a conventional conveyance system. The conveyance system described in Patent Document 1 includes a first track provided such that a device port is positioned on a side of and below one side of the first track, a second track provided along the first track and provided below and in parallel with the first track in an up-down direction such that the device port is positioned on a side of and below one side of the second track, and a plurality of ceiling conveyance vehicles configured to travel along each of the first track and the second track and each convey a conveyed object.

### Citation List

### Patent Literature

Patent Literature 1: Japanese Patent No. 6642577

### Summary of Invention

### Technical Problem

In the conventional conveyance system, with a configuration in which the ceiling conveyance vehicles traveling on the first track and the second track transfer the conveyed objects to the same transfer destination, efficiency of conveying the conveyed objects is improved. In the conveyance system, cases in which some malfunction occurs in a control device controlling operations of the ceiling conveyance vehicles have not yet been discussed. If some malfunction occurs in the control device, the conveyed objects may not possibly be transferred to the transfer destination.

One aspect of the present invention is to provide a conveyance system capable of avoiding a stoppage of transferring conveyed objects to a transfer destination.

### Solution to Problem

The invention is defined in claim 1. Advantageous aspects are described in the dependent claims.

The conveyance system according to one aspect of the present invention includes: a plurality of ceiling conveyance vehicles configured to convey conveyed objects and transfer the conveyed objects; a first track on which a first ceiling conveyance vehicle among the ceiling conveyance vehicles travels; a second track on which a second ceiling conveyance vehicle among the ceiling conveyance vehicles travels, the second track being disposed in parallel in an up-down direction or side by side in a right-left direction with the first track; and a control device configured to control operations of the ceiling conveyance vehicles. Each of the first ceiling conveyance vehicle and the second ceiling conveyance vehicle is able to transfer conveyed objects to the same transfer destination. The control device includes a first control unit configured to control operation of the first ceiling conveyance vehicle and the second control unit configured to control operation of the second ceiling conveyance vehicle. When one of the first control unit and the second control unit is inoperable, the other of the first control unit and the second control unit is operable.

In the conveyance system according to one aspect of the present invention, the control device includes the first control unit configured to control the operation of the first ceiling conveyance vehicle and the second control unit configured to control the operation of the second ceiling conveyance, and when one of the first control unit and the second control unit is inoperable, the other of the first control unit and the second control unit is operable. Consequently, in the conveyance system, for example, if some malfunction occurs in the first control unit and the operation of the first ceiling conveyance vehicle stops, the operation of the second ceiling conveyance vehicle can be continued by the second control unit. Thus, in the conveyance system, it is possible to continue transferring the conveyed objects to the transfer destination. As a result, the conveyance system can avoid stoppage of transferring the conveyed objects to the transfer destination

In an embodiment, the conveyance system may include a storage section temporarily storing the conveyed objects, and each of the first ceiling conveyance vehicle and the second ceiling conveyance vehicle may be able to transfer the conveyed objects to the storage section. This configuration enables operation to be performed in which, for example, a conveyed object that has been placed on the storage section by one ceiling conveyance vehicle of the first ceiling conveyance vehicle and the second ceiling conveyance vehicle is acquired from the storage section and is placed onto the transfer destination by the other ceiling conveyance vehicle. Thus, in the conveyance system, the efficiency of conveying the conveyed objects can be further improved.

In an embodiment, the conveyance system may include a first power feeding device configured to supply power to the first ceiling conveyance vehicle and a second power feeding device configured to supply power to the second ceiling conveyance vehicle, and when one of the first power feeding device and the second power feeding device is inoperable, the other of the first power feeding device and the second power feeding device may be operable. In this configuration, for example, even if some malfunction occurs in the first power feeding device and the operation of the first ceiling conveyance vehicle traveling on the first track stops, the operation of the second ceiling conveyance vehicle traveling on the second track can be continued by the second power feeding device.

In an embodiment, each of the first power feeding device and the second power feeding device may have a plurality of power feeder panels, and when one power feeder panel among the power feeder panels is inoperable, another power feeder panel may be operable. In this configuration, in the first power feeding device and the second power feeding device, even if, for example, some malfunction occurs in one power feeder panel, power is supplied to the ceiling conveyance vehicle from another power feeder panel, and thus the operation of the ceiling conveyance vehicle can be continued.

The first control unit includes a first communication device configured to send a conveyance command to the first ceiling conveyance vehicle, the second control unit includes a second communication device configured to send a conveyance command to the second ceiling conveyance vehicle, and when one of the first communication device and the second communication device is inoperable, the other of the first communication device and the second communication device is operable. In this configuration, even if some malfunction occurs in the first communication device and the operation of the first ceiling conveyance vehicle stops, the operation of the second ceiling conveyance vehicle is continued by the second communication device.

Each of the first communication device and the second communication device has a plurality of communication units, and when one communication unit of the communication units is inoperable, another communication unit is operable. In each of the first communication device and the second communication device, even if some malfunction occurs in one communication unit, the conveyance command is sent to the ceiling conveyance vehicle from another communication unit, and thus the operation of the ceiling conveyance vehicle is continued.

Each of the first control unit and the second control unit has a plurality of controllers, and each of the controllers is able to control each of the communication units. In this configuration, in each of the first control unit and the second control unit, even if some malfunction occurs in one controller, another controller controls the communication unit (outputs the conveyance command to the communication unit), and thus the operation of the ceiling conveyance vehicle is continued.

In an embodiment, the conveyance system may include a plurality of intrabay routes along a plurality of the transfer destinations and an interbay route connecting the intrabay routes, in which the first track may be disposed in the intrabay routes and the interbay route, and the second track may be disposed in part of the intrabay routes. In this configuration, an intrabay route with a large conveyance amount and an intrabay that is important in which a system failure is not allowed are made redundant, thereby avoiding stoppage of transferring the conveyed objects, whereas the other intrabays are not made redundant. Thus, in the conveyance system, while important portions are made redundant, the cost of the track can be suppressed.

In an embodiment, each of the first track and the second track may be disposed throughout the interbay route. In this configuration, it is possible to prevent the system from being failed in the interbay route connecting the intrabay routes.

The first track and the second track are disposed in parallel with each other in the up-down direction. In this configuration, space in the right-left direction is saved.

The first track and the second track are disposed side by side in the right-left direction. In this configuration, space in the up-down direction is saved.

In an embodiment, the two second tracks may be disposed above the first track, the two second tracks may be disposed side by side in the horizontal direction, one of the two second tracks may be disposed such that the transfer destination is positioned therebelow, and the other of the two second tracks may be disposed such that the storage section is positioned therebelow. In this configuration, the ceiling conveyance vehicles traveling on the second track can respectively access the transfer destination and the storage section simultaneously, thereby further improving the efficiency of conveyance.

### Advantageous Effects of Invention

With one aspect of the present invention, it is possible to avoid stoppage of transferring the conveyed objects to the transfer destination.

### Brief Description of Drawings

FIG. 1 is a plan view of a conveyance system according to an embodiment.
FIG. 2 is a front view of part of the conveyance system.
FIG. 3 is a diagram illustrating a configuration of a control device.
FIG. 4 is a front view of a conveyance system according to another embodiment.
FIG. 5 is a plan view of the conveyance system according to another embodiment.
FIG. 6 is a front view of part of the conveyance system in FIG. 5.

### Description of Embodiments

Preferred embodiments of the present invention will be described in detail below with reference to the accompanying drawings. In the description of the drawings, the same or corresponding elements will be denoted by the same reference signs and an overlapping description will be omitted.

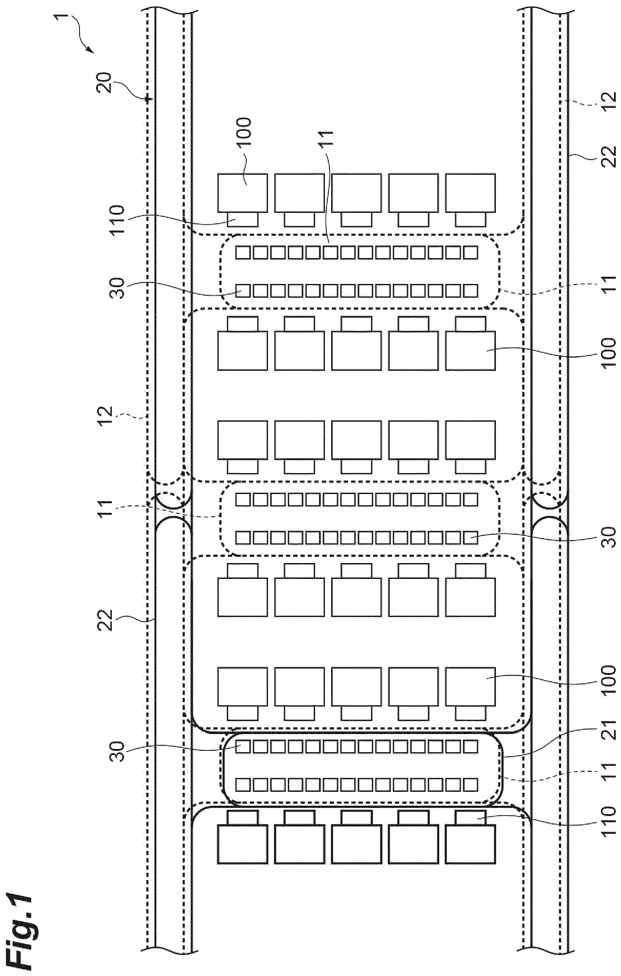

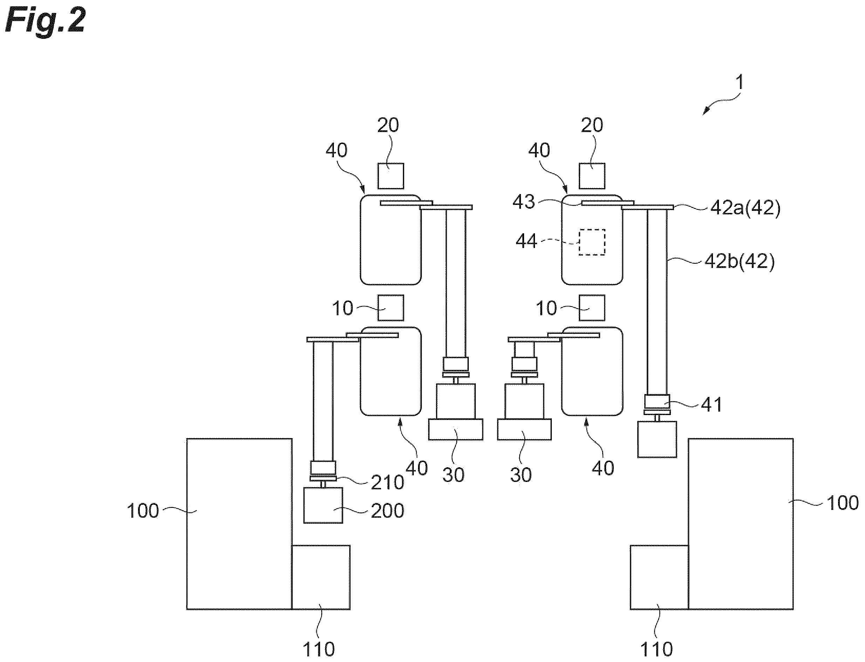

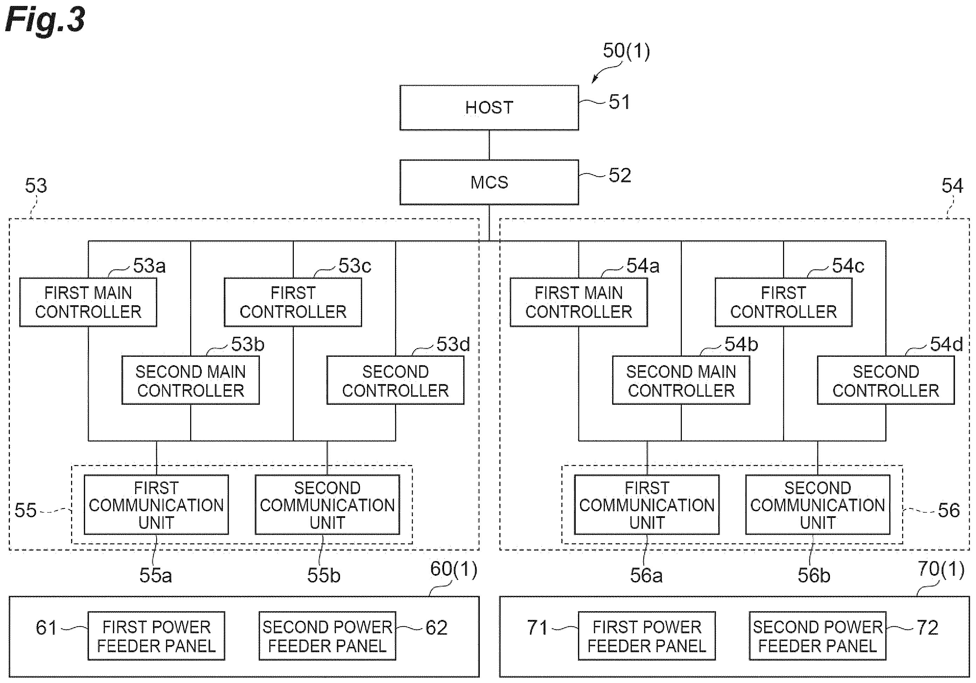

As illustrated in FIG. 1, a conveyance system 1 is a system for conveying a FOUP (conveyed object) 200. The conveyance system 1 includes a first track 10, a second track 20, a storage shelf (storage section) 30, a ceiling conveyance vehicle (first ceiling conveyance vehicle and second ceiling conveyance vehicle) 40 (refer to FIG. 2), a control device 50 (refer to FIG. 3), a first power feeding device 60, and a second power feeding device 70 (refer to FIG. 3). The conveyance system 1 is installed in a semiconductor manufacturing plant provided with a plurality of semiconductor processing apparatuses 100, for example. In the conveyance system 1, the FOUP 200 is transferred to a device port (transfer destination) 110 of the semiconductor processing apparatus 100 by the ceiling conveyance vehicle 40.

The first track 10 is a member on which the ceiling conveyance vehicle 40 travels, and the first track 10 is suspended from the ceiling. In the present embodiment, the conveyance system 1 constitutes a plurality of systems (bays). The conveyance system 1 includes a plurality of intrabay routes, which are traveling paths within bays, and interbay routes, which are traveling paths connecting different bays. The intrabay routes are disposed along vehicle routes and are located along a plurality of the device ports 110. The first track 10 includes intrabay tracks 11 disposed in a plurality of the intrabay routes and an interbay track 12 disposed in the interbay route. The intrabay track 11 is set such that the ceiling conveyance vehicle 40 travels one way clockwise. Similar to the intrabay track 11, the interbay track 12 is also set such that the ceiling conveyance vehicle 40 travels one way clockwise. In the first track 10, settings may be made such that the ceiling conveyance vehicle 40 travels one way counterclockwise.

The second track 20 is a member on which the ceiling conveyance vehicle 40 travels, and the second track 20 is suspended from the ceiling. The second track 20 includes an intrabay track 21 disposed in a part of the intrabay routes and an interbay track 22 disposed in the interbay route. The intrabay track 21 is set such that the ceiling conveyance vehicle 40 travels one way clockwise. Similar to the intrabay track 21, the interbay track 22 is also set such that the ceiling conveyance vehicle 40 travels one way clockwise. In the second track 20, settings may be made such that the ceiling conveyance vehicle 40 travels one way counterclockwise.

As illustrated in FIG. 2, the first track 10 and the second track 20 are disposed in parallel with each other in the up-down (vertical) direction. The first track 10 is positioned below the second track 20. In other words, the second track 20 is located above the first track 10. In FIG. 1, the first track 10 is illustrated as a dashed line and the second track 20 as a solid line.

As illustrated in FIG. 1, in the conveyance system 1, the device ports 110 are disposed outside the intrabay route, along the direction in which the first track 10 and second track 20 extend. The device ports 110 are provided to be positioned on a side of and below one of the first track 10 and the second track 20 that are disposed in parallel with each other in the up-down direction.

The device ports 110 each have the FOUPs 200 that are transferred from the ceiling conveyance vehicle 40 placed thereon, and transfer the FOUPs 200 to the corresponding semiconductor processing apparatuses 100. When semiconductor wafers accommodated in the FOUPs 200 are processed by the semiconductor processing apparatuses 100, the device ports 110 each transfer the FOUPs 200 from the semiconductor processing apparatuses 100, and thus have the FOUPs 200 placed thereon.

On each storage shelf 30, the FOUP 200 is placed thereon. The plurality of storage shelves 30 each support the FOUP 200. The storage shelves 30 are suspended from the ceiling, for example. Each storage shelf 30 can be an overhead buffer (OHB). A region on the storage shelf 30 can have the FOUP 200 placed thereon. That region on the storage shelf 30 is a temporary storage region onto which the ceiling conveyance vehicles 40 that stop on the first track 10 and the second track 20 can transfer the FOUP 200.

As illustrated in FIG. 2, the storage shelves 30 are provided on a side of and below of the other side with respect to the first track 10 and the second track 20, the other side being opposed to the one side on which the device ports 110 are provided. Specifically, when viewed from the vertical direction, the storage shelves 30 are provided on the side opposed to the device ports 110 with the first track 10 and the second track 20 interposed therebetween. The storage shelves 30 are provided inside the intrabay route having a loop shape.

Examples of the ceiling conveyance vehicle 40 include a crane suspended from a ceiling, an overhead hoist transfer (OHT), and the like. The FOUP 200 is a container (FOUP: Front Opening Unified Pod) for storing semiconductor wafers.

The ceiling conveyance vehicle 40 has a gripping unit 41, a hoisting mechanism 42, and a movement mechanism 43. The ceiling conveyance vehicle 40 has a transmitter/receiver 44 capable of communicating with the control device 50.

The gripping unit 41 is a device configured to grip and release the FOUP 200. The gripping unit 41 can grip a flange portion 210 of the FOUP 200. When the ceiling conveyance vehicle 40 acquires the FOUP 200 from the device port 110 and the storage shelf 30, the gripping unit 41 grips the flange portion 210 of the FOUP 200. When the ceiling conveyance vehicles 40 place the FOUP 200 onto the device port 110 and the storage shelf 30, the gripping unit 41 releases the flange portion 210 of the FOUP 200.

The hoisting mechanism 42 is a device configured to raise and lower the gripping unit 41 in the vertical direction. The hoisting mechanism 42 can raise and lower the gripping unit 41 in the vertical direction. The hoisting mechanism 42 has a winding mechanism 42a and a belt 42b. The winding mechanism 42a is supported by the movement mechanism 43. The winding mechanism 42a is a device configured to wind up and wind down the belt 42b in the vertical direction. The winding mechanism 42a can wind up and wind down the belt 42b in the vertical direction. The belt 42b is suspended from the winding mechanism 42a, and supports the gripping unit 41 at the lower end thereof. The hoisting mechanism 42 can wind up and wind down the FOUP 200 gripped by the gripping unit 41 for a distance at least allowing the FOUP 200 to reach the device port 110 and the storage shelf 30.

The movement mechanism 43 is a device configured to move the gripping unit 41 and the hoisting mechanism 42 from the ceiling conveyance vehicle 40 with respect to both sides thereof. Specifically, the movement mechanism 43 can move the gripping unit 41 and the hoisting mechanism 42 from the ceiling conveyance vehicle 40 in the horizontal direction orthogonal to the traveling direction of the ceiling conveyance vehicle 40. The movement mechanism 43 can move the gripping unit 41 and the hoisting mechanism 42 to above each of the device port 110 and the storage shelf 30. When the FOUP 200 is gripped by the gripping unit 41, the movement mechanism 43 can move the FOUP 200 to or from above the device port 110 and the storage shelf 30 in the vertical direction.

The ceiling conveyance vehicles 40 that stop at the same position in the traveling direction on each of the first track 10 and the second track 20 can transfer the FOUP 200 to both the device port 110 and the storage shelf 30, which are positioned in the side of and below the first track 10 and the second track 20. In other words, the ceiling conveyance vehicles 40 can transfer the FOUP 200 to the same device port 110 and the same storage shelf 30. Specifically, the FOUP 200 can be delivered (transferred) to and from the device port 110 by both of the ceiling conveyance vehicle 40 in the first track 10 and the ceiling conveyance vehicle 40 in the second track 20. Thus, both of the ceiling conveyance vehicle 40 in the first track 10 and the ceiling conveyance vehicle 40 in the second track 20 can deliver the FOUP 200 to and from the storage shelf 30.

The ceiling conveyance vehicle 40 moves the FOUP 200 upward above each of the device port 110 and the storage shelf 30, by operating the movement mechanism 43 from a state where the gripping unit 41 grips the flange portion 210 of the FOUP 200 directly under the first track 10 and the second track 20. Subsequently, the ceiling conveyance vehicle 40 operates the winding mechanism 42a to wind down the belt 42b, thereby lowering the FOUP 200 to place the FOUP 200 on the device port 110 or on the storage shelf 30. As described above, the ceiling conveyance vehicle 40 transfers (places) the FOUP 200 to (on) the device port 110 and the storage shelf 30.

Each of the ceiling conveyance vehicles 40 causes the gripping unit 41 to grip the flange portion 210 of the FOUP 200 placed on the device port 110 or on the storage shelf 30. Subsequently, each of the ceiling conveyance vehicles 40 causes the winding mechanism 42a to operate to wind up the belt 42b, thereby raising the FOUP 200. Subsequently, each of the ceiling conveyance vehicles 40 causes the movement mechanism 43 to operate to move the FOUP 200 to directly below the first track 10 and the second track 20. As described above, each of the ceiling conveyance vehicles 40 transfers (receives) the FOUP 200 from the device port 110 or the storage shelf 30.

The transmitter/receiver 44 is disposed at a predetermined position on the ceiling conveyance vehicle 40. The transmitter/receiver 44 of the ceiling conveyance vehicle 40 traveling on first track 10 can communicate with a first communication unit 55a or a second communication unit 55b (later described) of the control device 50. The transmitter/receiver 44 and the first communication unit 55a or the second communication unit 55b communicate with each other, for example, via feeder lines (not illustrated) laid along the first track 10. The transmitter/receiver 44 of the ceiling conveyance vehicle 40 traveling on the second track 20 can communicate with a first communication unit 56a or a second communication unit 56b (later described). The transmitter/receiver 44 and the first communication unit 56a or the second communication unit 56b communicate with each other, for example, via feeder lines (not illustrated) laid along the second track 20. The ceiling conveyance vehicle 40 conveys the FOUP 200, based on a command received by the transmitter/receiver 44.

As illustrated in FIG. 3, the control device 50 has a HOST 51, an MCS (Material Control System) 52, a first control unit 53, and a second control unit 54. The HOST 51, the MCS 52, the first control unit 53, and the second control unit 54 are electronic control units constituted by central processing unit (CPU), read only memory (ROM), random access memory (RAM), and the like. In the control device 50, the first control unit 53 and the second control unit 54 operate independently of each other. Consequently, even if one of the first control unit 53 and the second control unit 54 becomes inoperable, the other of the first control unit 53 and the second control unit 54 is still operable.

The HOST 51 is an upper-level controller. The HOST 51 can be a manufacturing execution system (MES). The HOST 51 outputs the conveyance command and a traveling command (hereinafter simply referred to as "command") to the MCS 52. The MCS 52, when obtaining a command from the HOST 51, outputs the command to the first control unit 53 or the second control unit 54 at a predetermined timing.

The first control unit 53 controls the operation of the ceiling conveyance vehicle 40 traveling on the first track 10. The first control unit 53 has a first main controller 53a, a second main controller 53b, a first controller 53c, a second controller 53d, and a first communication device 55.

The first main controller 53a and the second main controller 53b are master overhead vehicle controllers (MOHVCs). The first main controller 53a and the second main controller 53b send a command received from the MCS 52 to the first controller 53c or the second controller 53d. In the case of a system in which the first main controller 53a and the second main controller 53b are installed in each area, the first main controller 53a and the second main controller 53b are also configured to assign a command to the first controller 53c or the second controller 53d, whichever is appropriate. The first main controller 53a and the second main controller 53b have a similar configuration. The first main controller 53a and the second main controller 53b do not execute control simultaneously. The second main controller 53b operates when the first main controller 53a becomes inoperable. The first main controller 53a and the second main controller 53b may execute control simultaneously by sharing and processing a plurality of commands.

The first controller 53c and the second controller 53d are overhead hoist vehicle controllers (OHVCs). The first controller 53c and the second controller 53d output a command received from the first main controller 53a or the second main controller 53b to the first communication device 55 (first communication unit 55a, second communication unit 55b). The first controller 53c and the second controller 53d have a similar configuration. The first controller 53c and the second controller 53d do not execute control simultaneously. The second controller 53d operates when the first controller 53c becomes inoperable. The first controller 53c and the second controller 53d may execute control simultaneously by sharing and processing a plurality of commands.

The first communication device 55 has the first communication unit 55a and the second communication unit 55b. The first communication unit 55a and the second communication unit 55b communicate with the ceiling conveyance vehicle 40 traveling on the first track 10. The first communication unit 55a and the second communication unit 55b send commands to the ceiling conveyance vehicle 40. The first communication unit 55a and the second communication unit 55b have a similar configuration. The first communication unit 55a and the second communication unit 55b do not operate simultaneously. The second communication unit 55b operates when the first communication unit 55a becomes inoperable. Each of the first controller 53c and the second controller 53d can control each of the first communication unit 55a and the second communication unit 55b.

The second control unit 54 controls the operation of the ceiling conveyance vehicle 40 traveling on the second track 20. The second control unit 54 has a first main controller 54a, a second main controller 54b, a first controller 54c, a second controller 54d, and a second communication device 56.

The first main controller 54a and the second main controller 54b are MOHVCs. The first main controller 54a and the second main controller 54b send a command received from the MCS 52 to the first controller 54c or the second controller 54d. In the case of a system in which the first main controller 54a and the second main controller 54b are installed in each area, the first main controller 53a and the second main controller 53b are also configured to assign a command to the first controller 54c or the second controller 54d, whichever is appropriate. The first main controller 54a and the second main controller 54b have a similar configuration. The first main controller 54a and the second main controller 54b do not execute control simultaneously. The second main controller 54b operates when the first main controller 54a becomes inoperable. The first main controller 54a and the second main controller 54b may execute control simultaneously by sharing and processing a plurality of commands.

The first controller 54c and the second controller 54d are OHVCs. The first controller 54c and the second controller 54d output a command received from the first main controller 54a or the second main controller 54b to the second communication device 56 (first communication unit 56a, second communication unit 56b). The first controller 54c and the second controller 54d have a similar configuration. The first controller 54c and the second controller 54d do not execute control simultaneously. The second controller 54d operates when the first controller 54c becomes inoperable. The first controller 54c and the second controller 54d may execute control simultaneously by sharing and processing a plurality of commands.

The second communication device 56 has the first communication unit 56a and the second communication unit 56b. The first communication unit 56a and the second communication unit 56b communicate with the ceiling conveyance vehicle 40 traveling on the second track 20. The first communication unit 56a and the second communication unit 56b send commands to the ceiling conveyance vehicle 40. The first communication unit 56a and the second communication unit 56b have a similar configuration. The first communication unit 56a and the second communication unit 56b do not operate simultaneously. The second communication unit 56b operates when the first communication unit 56a becomes inoperable. Each of the first controller 54c and the second controller 54d can control each of the first communication unit 56a and the second communication unit 56b.

The first power feeding device 60 supplies power to the ceiling conveyance vehicle 40 traveling on the first track 10. The first power feeding device 60 supplies power to a plurality of feeder lines (not illustrated) provided along the first track 10. The first power feeding device 60 has a first power feeder panel 61 and a second power feeder panel 62. The first power feeder panel 61 and the second power feeder panel 62 can supply power independently of each other. The first power feeder panel 61 and the second power feeder panel 62 have a similar configuration. The first power feeder panel 61 and the second power feeder panel 62 do not operate simultaneously. The second power feeder panel 62 operates when the first power feeder panel 61 becomes inoperable.

The second power feeding device 70 supplies power to the ceiling conveyance vehicle 40 traveling on the second track 20. The second power feeding device 70 supplies power to a plurality of feeder lines (not illustrated) provided along the second track 20. The second power feeding device 70 has a first power feeder panel 71 and a second power feeder panel 72. The first power feeder panel 71 and the second power feeder panel 72 can supply power independently of each other. The first power feeder panel 71 and the second power feeder panel 72 have a similar configuration. The first power feeder panel 71 and the second power feeder panel 72 do not operate simultaneously. The second power feeder panel 72 operates when the first power feeder panel 71 becomes inoperable.

As explained above, in the conveyance system 1 according to the present embodiment, each of the ceiling conveyance vehicle 40 traveling on the first track 10 and the ceiling conveyance vehicle 40 traveling on the second track 20 can transfer the FOUP 200 to the same device port 110. Consequently, the conveyance system 1 can improve the efficiency of conveying the FOUP 200. In the conveyance system 1, the control device 50 has the first control unit 53 configured to control the operation of the ceiling conveyance vehicle 40 traveling on the first track 10 and the second control unit 54 configured to control the operation of the ceiling conveyance vehicle 40 traveling on the second track 20, and when one of the first control unit 53 and the second control unit 54 is inoperable, the other of the first control unit 53 and the second control unit 54 is operable. Consequently, in the conveyance system 1, if some malfunction occurs in the first control unit 53 and the operation of the first ceiling conveyance vehicle 40 traveling on the first track 10 stops, the operation of the ceiling conveyance vehicle 40 traveling on the second track 20 can be continued by the second control unit 54. Thus, in the conveyance system 1, it is possible to continue transferring the FOUP 200 to the device port 110. As a result, in the conveyance system 1, it is possible to avoid stoppage of transferring the FOUP 200 to the device port 110.

The conveyance system 1 in the present embodiment includes the storage shelf 30 temporarily storing the FOUP 200. Each of the ceiling conveyance vehicles 40 traveling on the first track 10 and the ceiling conveyance vehicle 40 traveling on the second track 20 can transfer the FOUP 200 to the storage shelf 30. This configuration enables operation to be performed in which, for example, the FOUP 200 that has been placed on the storage shelf 30 by one ceiling conveyance vehicle of the ceiling conveyance vehicle 40 on the first track 10 and the ceiling conveyance vehicle 40 on the second track 20 is received from the storage shelf 30 and is placed onto the device port 110 by the other overhead conveyance vehicle. Thus, in the conveyance system 1, the efficiency of conveying the FOUP 200 can be further improved.

The conveyance system 1 according to the present embodiment includes the first power feeding device 60 configured to supply power to the ceiling conveyance vehicle 40 traveling on the first track 10, and the second power feeding device 70 configured to supply power to the ceiling conveyance vehicle 40 traveling on the second track 20. When one of the first power feeding device 60 and the second power feeding device 70 is inoperable, the other of the first power feeding device 60 and the second power feeding device 70 power feeders is operable. In this configuration, for example, even if some malfunction occurs in the first power feeding device 60 and the operation of the ceiling conveyance vehicle 40 traveling on the first track 10 stops, the operation of the ceiling conveyance vehicle 40 traveling on the second track 20 can be continued by the second power feeding device 70.

In the conveyance system 1, the first power feeding device 60 has the first power feeder panel 61 and the second power feeder panel 62, and the second power feeding device 70 has the first power feeder panel 71 and the second power feeder panel 72. When the first power feeder panels 61, 71 are inoperable, the second power feeder panels 62, 72 are operable. In this configuration, in the first power feeding device 60 and the second power feeding device 70, even if, for example, some malfunction occurs in the first power feeder panels 61, 71, power is supplied to the ceiling conveyance vehicle 40 from the second power feeder panels 62, 72, and thus the operation of the ceiling conveyance vehicle 40 can be continued.

In the conveyance system 1 according to the present embodiment, the first control unit 53 includes the first communication device 55 configured to transmit commands to the ceiling conveyance vehicle 40 traveling on the first track 10. The second control unit 54 includes the second communication device 56 configured to transmit commands to the ceiling conveyance vehicle 40 traveling on the second track 20. When one of the first communication device 55 and the second communication device 56 is inoperable, the other of the first communication device 55 and the second communication device 56 is operable. In this configuration, even if some malfunction occurs in the first communication device 55 and the operation of the ceiling conveyance vehicle 40 traveling on the first track 10 stops, the operation of the ceiling conveyance vehicle 40 traveling on the second track 20 is continued by the second communication device 56.

In the conveyance system 1 according to the present embodiment, the first communication device 55 has the first communication unit 55a and the second communication unit 55b, and the second communication device 56 has the first communication unit 56a and the second communication unit 56b. When the first communication units 55a, 56a are inoperable, the second communication units 55b, 56b are operable. In this configuration, in each of the first communication device 55 and the second communication device 56, even if some malfunction occurs in the first communication units 55a, 56a, commands are transmitted from the second communication units 55b, 56b to the ceiling conveyance vehicle 40, and thus the operation of the ceiling conveyance vehicle 40 can be continued.

In the conveyance system 1 according to the present embodiment, the first control unit 53 has the first controller 53c and the second controller 53d, and the second control unit 54 has the first controller 54c and the second controller 54d. Each of the first controllers 53c, 54c and the second controllers 53d, 54d can control each of the first communication units 55a, 56a and the second communication units 55b, 56b. In this configuration, in each of the first control unit 53 and the second control unit 54, even if some malfunction occurs in the first controllers 53c, 54c, the second controllers 53d, 54d can control the first communication units 55a, 56a or the second communication units 55b, 56b (can output commands to the first communication units 55a, 56a or the second communication units 55b, 56b), and thus the operation of the ceiling conveyance vehicle 40 can be continued.

The conveyance system 1 according to the present embodiment includes the plurality of intrabay routes along the plurality of device ports 110 and the interbay route connecting the intrabay routes. The first track 10 includes the intrabay track 11 disposed in the intrabay routes and the interbay track 12 disposed in the interbay route. The second track 20 includes the intrabay track 21 disposed in part of the intrabay routes. In this configuration, an intrabay route with a large conveyance amount and an intrabay that is important in which a system failure is not allowed are made redundant, thereby avoiding stoppage of transferring the conveyed objects, whereas the other intrabays are not made redundant. Thus, in the conveyance system 1, while important portions are made redundant, the cost of the track can be suppressed.

In the conveyance system 1 according to the present embodiment, each of the first track 10 and the second track 20 is disposed throughout the interbay route. In this configuration, it is possible to prevent the system from being failed in the interbay route connecting the intrabay routes.

In the conveyance system 1 according to the present embodiment, the first track 10 and the second track 20 are disposed in parallel with each other in the up-down direction. In this configuration, space in the right-left direction can be saved.

In the foregoing, the embodiment of the present invention has been described above, but the present invention is not necessarily limited to the foregoing embodiment, and various modifications are possible within a scope not departing from the gist of the invention.

In the foregoing embodiment, a form in which the conveyance system 1 includes the first track 10 and the second track 20 is described as an example. However, three or more tracks (third track, fourth track, and so on) may be provided. In this case, three or more tracks may be disposed in parallel with each other in the up-down direction.

In the above embodiment, as illustrated in FIG. 1, a form in which the second track 20 includes the intrabay track 21 disposed in part of the intrabay routes is described as an example. However, the second track 20 may be disposed in all the intrabay routes. With this configuration, it is possible to avoid the stoppage of transferring the FOUP 200 to the device port 110 in all the intrabay routes.

A form in which the first track 10 and the second track 20 are disposed at the same position in the up-down direction is described as an example.

In the above embodiment, a form in which the first control unit 53 has the first main controller 53a, the second main controller 53b, the first controller 53c, and the second controller 53d is described as an example. However, the first control unit 53 may further have another main controller and another controller. The same is true for the second control unit 54.

In the above embodiment, a form in which the first communication device 55 has the first communication unit 55a and the second communication unit 55b is described as an example. However, the first communication device 55 may further have another communication unit. The same is true for the second communication device 56.

In the above embodiment, a form in which the first power feeding device 60 has the first power feeder panel 61 and the second power feeder panel 62 is described as an example. However, the first power feeding device 60 may further have another power feeder panel. The same is true for the second power feeding device 70.

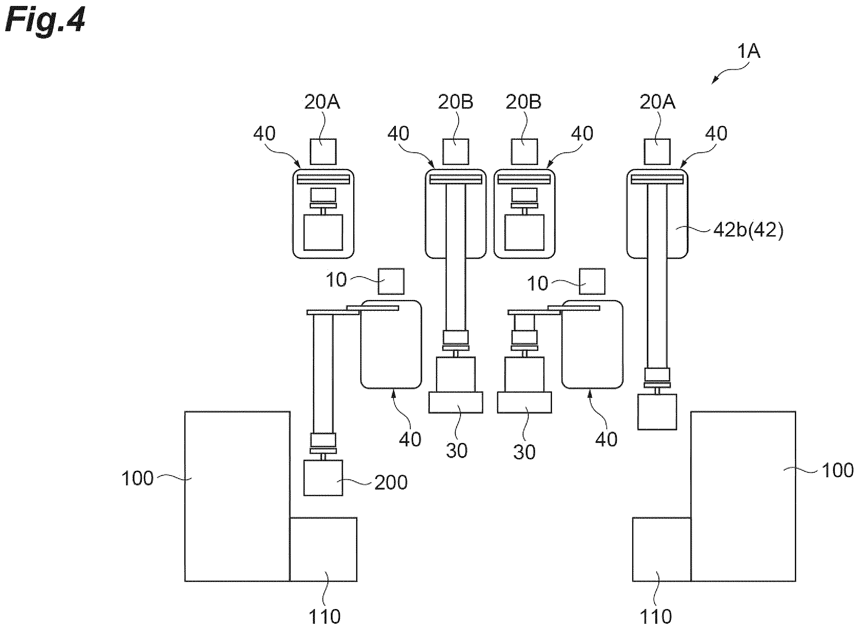

In addition to the above embodiment, the two second tracks 20A, 20B may be disposed side by side in the right-left (horizontal) direction in the conveyance system 1A, as illustrated in FIG. 4. The second track 20A is disposed such that the device port 110 is positioned therebelow. The second track 20B is disposed such that the storage shelf 30 is positioned therebelow. In this configuration, the ceiling conveyance vehicle 40 traveling on the second track 20A transfers the FOUP 200 to the device port 110, and the ceiling conveyance vehicle 40 traveling on the second track 20B transfers the FOUP 200 to the storage shelf 30. In this configuration, the ceiling conveyance vehicles 40 traveling on the second tracks 20A, 20B can respectively access the device port 110 and the storage shelf 30 simultaneously, further improving the efficiency of conveyance.

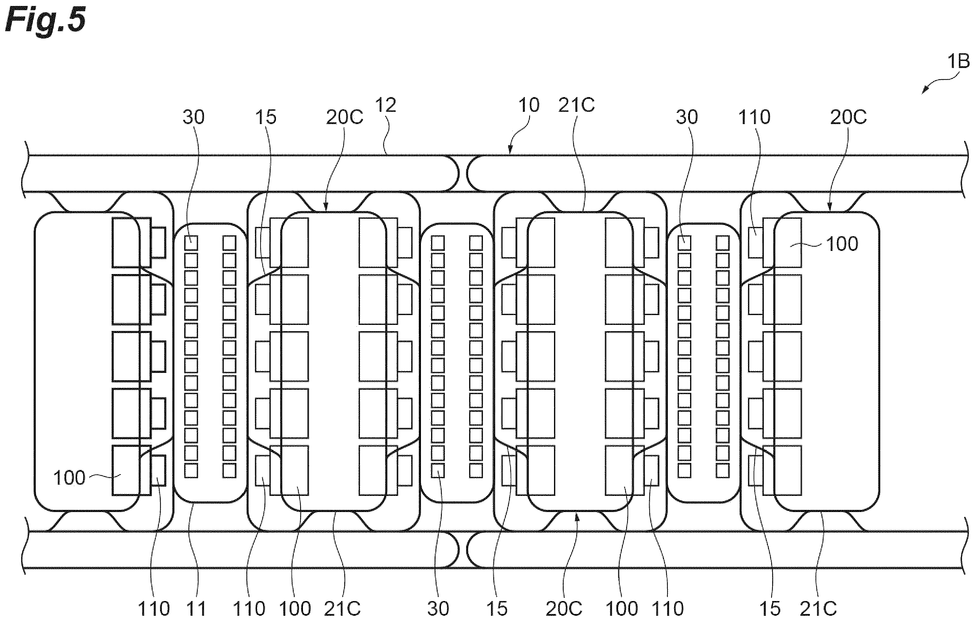

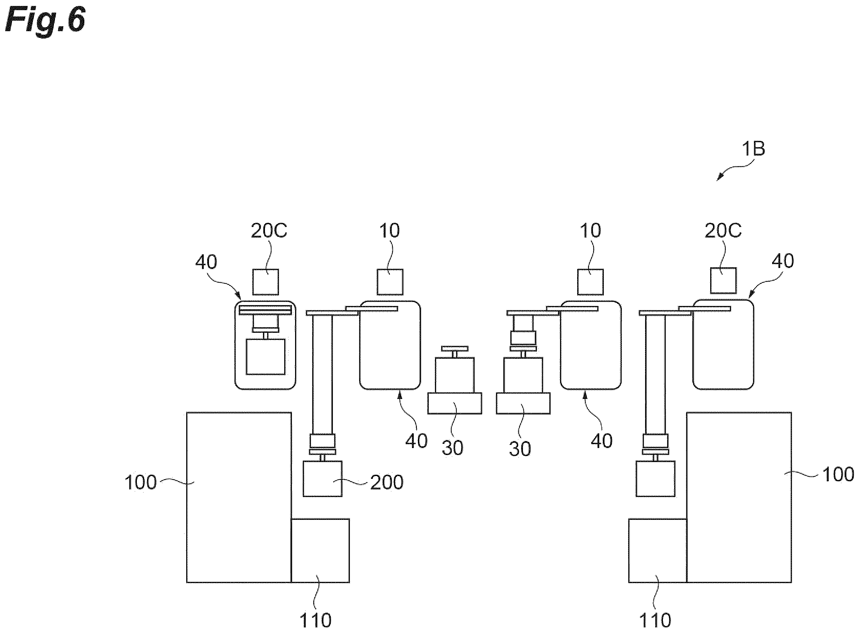

In the above embodiment, a form in which the first track 10 is positioned below the second track 20 is described as an example. However, as illustrated in FIG. 5 and FIG. 6, the first track 10 and the second track 20C may be disposed side by side in the right-left direction in the conveyance system 1B. As illustrated in FIG. 5, the second track 20C has a loop shape. The second track 20C includes an intrabay track 21C disposed in an intrabay route spanning the two adjacent semiconductor processing apparatuses 100. The second track 20C is connected to the first track 10 with a branch track 15. Consequently, the ceiling conveyance vehicle 40 can move from the second track 20 into the first track 10 (from the first track 10 into the second track 20) without going through the interbay route. In the conveyance system 1B, space in the up-down direction can be saved.

The second track 20C does not need to be connected to the first track 10 or the interbay route with the branch track 15. Specifically, the second track 20C may be provided independently. Moreover, the second track 20 does not need to have a loop shape. For example, the second track 20C may have a linear shape along an array direction of the semiconductor processing apparatuses 100. In these configurations, the ceiling conveyance vehicle 40 traveling on the second track 20C transfers (acquires) the FOUP 200 from the device port 110 of the semiconductor processing apparatus 100 that has completed processing, and conveys the FOUP 200 to a predetermined position.

In the above embodiment, a form in which the conveyed object is the FOUP 200 is described as an example. However, the conveyed object may be, for example, a container for storing a glass substrate, a reticle pod, a FOSB, a SMIF Pod, a general component, and the like.

In the above embodiment, a form in which the conveyance system 1 is installed in a semiconductor manufacturing plant is described as an example. However, the conveyance system is also applicable to other facilities, not being limited to the semiconductor manufacturing plant.

### Reference Signs List

1, 1A, 1B... conveyance system
10... first track
20, 20A, 20B, 20C ... second track
30... storage shelf (storage section)
40... ceiling conveyance vehicle (first ceiling conveyance vehicle, second ceiling conveyance vehicle)
50... control device
53... first control unit
54... second control unit
55... first communication device
55a... first communication unit
55b... second communication unit
56... second communication device
56a... first communication unit
56b... second communication unit
60... first power feeding device
61... first power feeder panel
62... second power feeder panel
70... second power feeding device
71... first power feeder panel
72... second power feeder panel
110... device port (transfer destination)
200... FOUP (conveyed object)

## Claims

1. A conveyance system (1, 1A, 1B) comprising:
a plurality of ceiling conveyance vehicles (40) configured to convey conveyed objects (200) and transfer the conveyed objects (200);
a first track (10) on which a first ceiling conveyance vehicle among the ceiling conveyance vehicles (40) travels;
a second track (20, 20A, 20B, 20C) on which a second ceiling conveyance vehicle among the ceiling conveyance vehicles (40) travels, the second track (20, 20A, 20B, 20C) being disposed in parallel in an up-down direction or side by side in a right-left direction with the first track (10); and
a control device (50) configured to control operations of the ceiling conveyance vehicles (40), wherein
each of the first ceiling conveyance vehicle and the second ceiling conveyance vehicle is able to transfer conveyed objects (200) to a same transfer destination (110),
the control device (50) includes a first control unit (53) configured to control operation of the first ceiling conveyance vehicle and a second control unit (54) configured to control operation of the second ceiling conveyance vehicle, and
when one of the first control unit (53) and the second control unit (54) is inoperable, the other of the first control unit (53) and the second control unit (54) is operable,
wherein the first control unit (53) includes a first communication device (55) configured to send a conveyance command to the first ceiling conveyance vehicle,
the second control unit (54) includes a second communication device (56) configured to send a conveyance command to the second ceiling conveyance vehicle, and
when one of the first communication device (55) and the second communication device (56) is inoperable, the other of the first communication device (55) and the second communication device (56) is operable,
**characterized in that**
each of the first communication device (55) and the second communication device (56) has a plurality of communication units (55a, 55b, 56a, 56b), and
when one communication unit of the communication units (55a, 55b, 56a, 56b) is inoperable, another communication unit is operable, and
each of the first control unit (53) and the second control unit (54) has a plurality of controllers (53a, 53b, 53c, 53d, 54a, 54b, 54c, 54d), and
each of the controllers (53a, 53b, 53c, 53d, 54a, 54b, 54c, 54d) is able to control each of the communication units.

2. A conveyance system (1, 1A, 1B) as claimed in claim 1, comprising a storage section (30) temporarily storing the conveyed objects (200), wherein
each of the first ceiling conveyance vehicle and the second ceiling conveyance vehicle is able to transfer the conveyed objects (200) to the storage section (30).

3. The conveyance system (1, 1A, 1B) according to claim 1 or 2, comprising a first power feeding device (60) configured to supply power to the first ceiling conveyance vehicle and a second power feeding device (70) configured to supply power to the second ceiling conveyance vehicle, wherein
when one of the first power feeding device (60) and the second power feeding device (70) is inoperable, the other of the first power feeding device (60) and the second power feeding device (70) is operable.

4. The conveyance system (1, 1A, 1B) according to claim 3, wherein
each of the first power feeding device (60) and the second power feeding device (70) has a plurality of power feeder panels (61, 62, 71, 72), and
when one power feeder panel among the power feeder panels (61, 62, 71, 72) is inoperable, another power feeder panel is operable.

5. The conveyance system (1, 1A, 1B) according to any one of the preceding claims, comprising a plurality of intrabay routes along a plurality of the transfer destinations (110) and an interbay route connecting the intrabay routes, wherein
the first track (10) is disposed in the intrabay routes and the interbay route, and the second track (20, 20A, 20B, 20C) is disposed in part of the intrabay routes.

6. The conveyance system (1, 1A, 1B) according to claim 5, wherein each of the first track (10) and the second track (20, 20A, 20B, 20C) is disposed throughout the interbay route.

7. The conveyance system (1, 1A, 1B) according to any one of the preceding claims,
wherein the first track (10) and the second track (20, 20A, 20B, 20C) are disposed in parallel with each other in the up-down direction.

8. The conveyance system (1, 1A, 1B) according to any one of claims 1 to 6,
wherein the first track (10) and the second track (20, 20A, 20B, 20C) are disposed side by side in the right-left direction.

9. The conveyance system (1, 1A, 1B) according to claim 2, wherein
two second tracks (20, 20A, 20B, 20C) are disposed above the first track (10),
the two second tracks (20, 20A, 20B, 20C) are disposed side by side in the right-left direction,
one of the two second tracks (20, 20A, 20B, 20C) is disposed such that the transfer destination (110) is positioned therebelow, and
the other of the two second tracks (20, 20A, 20B, 20C) is disposed such that the storage section (30) is positioned therebelow.

## Patentansprüche

1. Ein Beförderungssystem (1, 1A, 1B), das folgende Merkmale aufweist:
eine Mehrzahl von Deckenbeförderungsfahrzeugen (40), die dazu konfiguriert sind, beförderte Objekte (200) zu befördern und die beförderten Objekte (200) zu transportieren;
eine erste Bahn (10), auf der ein erstes Deckenbeförderungsfahrzeug aus den Deckenbeförderungsfahrzeugen (40) läuft;
eine zweite Bahn (20, 20A, 20B, 20C), auf der ein zweites Deckenbeförderungsfahrzeug aus den Deckenbeförderungsfahrzeugen (40) läuft, wobei die zweite Bahn (20, 20A, 20B, 20C) in einer Oben-unten-Richtung parallel zu oder in einer Rechts-links-Richtung neben der ersten Bahn (10) angeordnet ist; und
eine Steuervorrichtung (50), die dazu konfiguriert ist, einen Betrieb der Deckenbeförderungsfahrzeuge (40) zu steuern, wobei
jedes aus dem ersten Deckenbeförderungsfahrzeug und dem zweiten Deckenbeförderungsfahrzeug dazu fähig ist, beförderte Objekte (200) zu einem gleichen Transferziel (110) zu transportieren,
die Steuervorrichtung (50) eine erste Steuereinheit (53), die dazu konfiguriert ist, einen Betrieb des ersten Deckenbeförderungsfahrzeugs zu steuern, und eine zweite Steuereinheit (54) umfasst, die dazu konfiguriert ist, einen Betrieb des zweiten Deckenbeförderungsfahrzeugs zu steuern, und
dann, wenn eine aus der ersten Steuereinheit (53) und der zweiten Steuereinheit (54) nicht betriebsfähig ist, die andere aus der ersten Steuereinheit (53) und der zweiten Steuereinheit (54) betriebsfähig ist,
wobei die erste Steuereinheit (53) eine erste Kommunikationsvorrichtung (55) umfasst, die dazu konfiguriert ist, einen Beförderungsbefehl an das erste Deckenbeförderungsfahrzeug zu senden,
die zweite Steuereinheit (54) eine zweite Kommunikationsvorrichtung (56) umfasst, die dazu konfiguriert ist, einen Beförderungsbefehl an das zweite Deckenbeförderungsfahrzeug zu senden, und
dann, wenn eine aus der ersten Kommunikationsvorrichtung (55) und der zweiten Kommunikationsvorrichtung (56) nicht betriebsfähig ist, die andere aus der ersten Kommunikationsvorrichtung (55) und der zweiten Kommunikationsvorrichtung (56) betriebsfähig ist,
**dadurch gekennzeichnet, dass** jede aus der ersten Kommunikationsvorrichtung (55) und der zweiten Kommunikationsvorrichtung (56) eine Mehrzahl von Kommunikationseinheiten (55a, 55b, 56a, 56b) aufweist und
dann, wenn eine Kommunikationseinheit der Kommunikationseinheiten (55a, 55b, 56a, 56b) nicht betriebsfähig ist, eine andere Kommunikationseinheit betriebsfähig ist und
jede aus der ersten Steuereinheit (53) und der zweiten Steuereinheit (54) eine Mehrzahl von Steuerungen (53a, 53b, 53c, 53d, 54a, 54b, 54c, 54d) aufweist und
jede der Steuerungen (53a, 53b, 53c, 53d, 54a, 54b, 54c, 54d) dazu fähig ist, jede der Kommunikationseinheiten zu steuern.

2. Ein Beförderungssystem (1, 1A, 1B) gemäß Anspruch 1, das ein Speichersegment (30) aufweist, das die beförderten Objekte (200) vorübergehend speichert, wobei
jedes aus dem ersten Deckenbeförderungsfahrzeug und dem zweiten Deckenbeförderungsfahrzeug dazu fähig ist, die beförderten Objekten (200) zu dem Speichersegment (30) zu transportieren.

3. Das Beförderungssystem (1, 1A, 1B) gemäß Anspruch 1 oder 2, das eine erste Leistungseinspeisevorrichtung (60), die dazu konfiguriert ist, das erste Deckenbeförderungsfahrzeug mit Leistung zu versorgen, und eine zweite Leistungseinspeisevorrichtung (70) aufweist, die dazu konfiguriert ist, das zweite Deckenbeförderungsfahrzeug mit Leistung zu versorgen, wobei
dann, wenn aus der ersten Leistungseinspeisevorrichtung (60) und der zweiten Leistungseinspeisevorrichtung (70) nicht betriebsfähig ist, die andere aus der ersten Leistungseinspeisevorrichtung (60) und der zweiten Leistungseinspeisevorrichtung (70) betriebsfähig ist.

4. Das Beförderungssystem (1, 1A, 1B) gemäß Anspruch 3, wobei
jede aus der ersten Leistungseinspeisevorrichtung (60) und der zweiten Leistungseinspeisevorrichtung (70) eine Mehrzahl von Leistungseinspeiserkonsolen (61, 62, 71, 72) aufweist und
dann, wenn eine Leistungseinspeiserkonsole aus den Leistungseinspeiserkonsolen (61, 62, 71, 72) nicht betriebsfähig ist, die andere Leistungseinspeiserkonsole betriebsfähig ist.

5. Das Beförderungssystem (1, 1A, 1B) gemäß einem der vorhergehenden Ansprüche, das eine Mehrzahl von Innerfeldrouten entlang einer Mehrzahl der Transferziele (110) und eine Zwischenfeldroute aufweist, welche die Innerfeldrouten verbindet, wobei
die erste Bahn (10) in den Innerfeldrouten und der Zwischenfeldroute angeordnet ist und die zweite Bahn (20, 20A, 20B, 20C) in einem Teil der Innerfeldrouten angeordnet ist.

6. Das Beförderungssystem (1, 1A, 1B) gemäß Anspruch 5, wobei jede aus der ersten Bahn (10) und der zweiten Bahn (20, 20A, 20B, 20C) auf der gesamten Zwischenfeldroute angeordnet ist.

7. Das Beförderungssystem (1, 1A, 1B) gemäß einem der vorhergehenden Ansprüche, wobei die erste Bahn (10) und die zweite Bahn (20, 20A, 20B, 20C) in der Oben-unten-Richtung parallel zueinander angeordnet sind.

8. Das Beförderungssystem (1, 1A, 1B) gemäß einem der Ansprüche 1 bis 6, wobei die erste Bahn (10) und die zweite Bahn (20, 20A, 20B, 20C) in der Rechts-links-Richtung nebeneinander angeordnet sind.

9. Das Beförderungssystem (1, 1A, 1B) gemäß Anspruch 2, wobei
zwei zweite Bahnen (20, 20A, 20B, 20C) über der ersten Bahn (10) angeordnet sind,
die zwei zweiten Bahnen (20, 20A, 20B, 20C) in der Rechts-links-Richtung nebeneinander angeordnet sind,
eine der zwei zweiten Bahnen (20, 20A, 20B, 20C) derart angeordnet ist, dass das Transferziel (110) darunter positioniert ist, und
die andere der zwei zweiten Bahnen (20, 20A, 20B, 20C) derart angeordnet ist, dass das Speichersegment (30) darunter positioniert ist.

## Revendications

1. Système de transport (1, 1A, 1B) comprenant :
une pluralité de véhicules de transport suspendus (40) configurés pour acheminer des objets transportés (200) et transférer les objets transportés (200) ;
une première voie (10) sur laquelle circule un premier véhicule de transport suspendu parmi les véhicules de transport suspendus (40) ;
une deuxième voie (20, 20A, 20B, 20C) sur laquelle circule un deuxième véhicule de transport suspendu parmi les véhicules de transport suspendus (40), la deuxième voie (20, 20A, 20B, 20C) étant disposée parallèlement à la première voie (10) dans un sens vertical ou côte à côte à la première voie dans un sens horizontal ; et
un dispositif de commande (50) configuré pour commander le fonctionnement des véhicules de transport suspendus (40), dans lequel
chacun du premier véhicule de transport suspendu et du deuxième véhicule de transport suspendu est capable de transférer des objets transportés (200) vers une même destination de transfert (110),
le dispositif de commande (50) inclut une première unité de commande (53) configurée pour commander le fonctionnement du premier véhicule de transport suspendu et une deuxième unité de commande (54) configurée pour commander le fonctionnement du deuxième véhicule de transport suspendu, et
lorsqu'une de la première unité de commande (53) et de la deuxième unité de commande (54) est hors service, l'autre de la première unité de commande (53) et de la deuxième unité de commande (54) est opérationnelle,
dans lequel la première unité de commande (53) inclut un premier dispositif de communication (55) configuré pour envoyer une commande de transport au premier véhicule de transport suspendu,
la deuxième unité de commande (54) inclut un deuxième dispositif de communication (56) configuré pour envoyer une commande de transport au deuxième véhicule de transport suspendu, et
lorsqu'un du premier dispositif de communication (55) et du deuxième dispositif de communication (56) est hors service, l'autre du premier dispositif de communication (55) et du deuxième dispositif de communication (56) est opérationnel,
**caractérisé en ce que** chacun du premier dispositif de communication (55) et du deuxième dispositif de communication (56) présentent une pluralité d'unités de communication (55a, 55b, 56a, 56b), et
lorsqu'une unité de communication des unités de communication (55a, 55b, 56a, 56b) est hors service, une autre unité de communication est opérationnelle, et
chacune de la première unité de commande (53) et de la deuxième unité de commande (54) présente une pluralité de contrôleurs (53a, 53b, 53c, 53d, 54a, 54b, 54c, 54d), et
chacun des contrôleurs (53a, 53b, 53c, 53d, 54a, 54b, 54c, 54d) est capable de contrôler chacune des unités de communication.

2. Système de transport (1, 1A, 1B) selon la revendication 1, comprenant une section de stockage (30) destinée à stocker temporairement les objets transportés (200), dans lequel
chacun du premier véhicule de transport suspendu et du deuxième véhicule de transport suspendu est capable de transférer les objets transportés (200) vers la section de stockage (30).

3. Système de transport (1, 1A, 1B) selon la revendication 1 ou 2, comprenant un premier dispositif d'alimentation en énergie (60) configuré pour alimenter en énergie le premier véhicule de transport suspendu et un deuxième dispositif d'alimentation en énergie (70) configuré pour alimenter en énergie le deuxième véhicule de transport suspendu, dans lequel
lorsque l'un du premier dispositif d'alimentation en énergie (60) et du deuxième dispositif d'alimentation en énergie (70) est hors service, l'autre du premier dispositif d'alimentation en énergie (60) et du deuxième dispositif d'alimentation en énergie (70) est opérationnel.

4. Système de transport (1, 1A, 1B) selon la revendication 3, dans lequel
chacun du premier dispositif d'alimentation en énergie (60) et du deuxième dispositif d'alimentation en énergie (70) comporte une pluralité de panneaux d'alimentation en énergie (61, 62, 71, 72), et
lorsqu'un des panneaux d'alimentation en énergie (61, 62, 71, 72) est hors service, un autre panneau d'alimentation en énergie est opérationnel.

5. Système de transport (1, 1A, 1B) selon l'une quelconque des revendications précédentes, comprenant une pluralité d'itinéraires intra-baies le long d'une pluralité de destinations de transfert (110) et un itinéraire inter-baies reliant les itinéraires intra-baies, dans lequel
la première voie (10) est disposée sur les itinéraires intra-baies et sur l'itinéraire inter-baies, tandis que la deuxième voie (20, 20A, 20B, 20C) est disposée sur une partie des itinéraires intra-baies.

6. Système de transport (1, 1A, 1B) selon la revendication 5, dans lequel chacune de la première voie (10) et de la deuxième voie (20, 20A, 20B, 20C) est disposée sur l'ensemble de l'itinéraire inter-baies.

7. Système de transport (1, 1A, 1B) selon l'une quelconque des revendications précédentes, dans lequel la première voie (10) et la deuxième voie (20, 20A, 20B, 20C) sont disposées parallèlement l'une à l'autre dans le sens vertical.

8. Système de transport (1, 1A, 1B) selon l'une quelconque des revendications 1 à 6, dans lequel la première voie (10) et la deuxième voie (20, 20A, 20B, 20C) sont disposées côte à côte dans le sens horizontal.

9. Système de transport (1, 1A, 1B) selon la revendication 2, dans lequel
deux deuxièmes voies (20, 20A, 20B, 20C) sont disposées au-dessus de la première voie (10),
les deux deuxièmes voies (20, 20A, 20B, 20C) sont disposées côte à côte dans le sens horizontal,
l'une des deux deuxièmes voies (20, 20A, 20B, 20C) est disposée de sorte que la destination de transfert (110) est positionnée en dessous de celle-ci, et
l'autre des deux deuxièmes voies (20, 20A, 20B, 20C) est disposée de sorte que la section de stockage (30) est positionnée en dessous de celle-ci.
